# EUROPEAN PATENT SPECIFICATION

(11) **EP 3 378 016 B1**
(45) Date of publication and mention of the grant of the patent: **13.11.2024**
(21) Application number: 15908983.8
(22) Date of filing: 20.11.2015
(51) Int. Cl.: G06Q 10/04, G06Q 10/02, G06Q 30/02

(54) **GENERATING AND VERIFYING INSTRUCTIONS FOR A RETAIL SEARCH APPLIANCE**
ERZEUGUNG UND ÜBERPRÜFUNG VON BEFEHLEN FÜR EINE EINZELHANDELSSUCHANWENDUNG
GÉNÉRATION ET VÉRIFICATION D'INSTRUCTIONS POUR UN APPAREIL DE RECHERCHE DE VENTE AU DÉTAIL

(43) Date of publication of application: 26.09.2018
(73) Proprietor: Hewlett Packard Enterprise Development LP, Houston, TX 77070 (US)
(72) Inventor: STOHRER, Horst, Houston, TX 77070 (US); CHERUKURI, Praveen, Houston, TX 77070 (US); ZAMZOW, Joseph, Houston, TX 77070 (US)
(74) Representative: Gill Jennings & Every LLP
(86) International application number: PCT/US2015/061934
(87) International publication number: WO 2017/086999

(56) References cited:
- US-A1- 2007 021 989
- US-A1- 2008 140 463
- US-A1- 2011 191 180
- US-A1- 2013 282 748
- US-A1- 2014 108 418
- US-A1- 2015 235 295
- US-B2- 6 873 968
- FINN HAEDICKE ET AL: "metaSMT: focus on your application not on solver integration", INTERNATIONAL JOURNAL ON SOFTWARE TOOLS FOR TECHNOLOGY TRANSFER, 3 November 2011 (2011-11-03), DE, pages 1 - 8, XP055626050, ISSN: 1433-2779
- SUYAMA T ET AL: "Solving satisfiability problems using logic synthesis and reconfigurable hardware", SYSTEM SCIENCES, 1998., PROCEEDINGS OF THE THIRTY-FIRST HAWAII INTERNA TIONAL CONFERENCE ON KOHALA COAST, HI, USA 6-9 JAN. 1998, LOS ALAMITOS, CA, USA,IEEE COMPUT. SOC, US, vol. 7, 6 January 1998 (1998-01-06), pages 179 - 186, XP010262780, ISBN: 978-0-8186-8255-1, DOI: 10.1109/HICSS.1998.649212
- MARCO PLATZNER ET AL: "Acceleration of satisfiability algorithms by reconfigurable hardware", INTERNATIONAL WORKSHOP ON FIELD PROGRAMMABLE LOGIC AND APPLICATIONS, vol. 1482, 31 August 1998 (1998-08-31), Cham, pages 69 - 78, XP055626149, ISSN: 0302-9743, ISBN: 978-3-319-10403-4, DOI: 10.1007/BFb0055234
- HOSSEIN M SHEINI ET AL: "From Propositional Satisfiability to Satisfiability Modulo Theories", 1 January 2006, THEORY AND APPLICATIONS OF SATISFIABILITY TESTING - SAT 2006 LECTURE NOTES IN COMPUTER SCIENCE;;LNCS, SPRINGER, BERLIN, DE, PAGE(S) 1 - 9, ISBN: 978-3-540-37206-6, XP019038207

## Description

### BACKGROUND

Retail offerings often rely heavily on rules and constraints to provide for restrictive pricing. For example, an airline offering may contain a particular fare subject to a rule or constraint that the corresponding trip spans only a weekend. Such restricted pricing is increasingly being employed in other retail product spaces, such as online retailing, where offers are discounted on specific combinations of products or to specific types of users. Such systems are highly complex. For example, airline flight search has been demonstrated to be an NP-Complete (or nondeterministic polynomial time complete) problem space. In terms of computation complexity for a given problem, NP-complete signifies that the time required to solve a problem using increases (often exponentially) as the size of the problem grows.

XP055626050 relates to the use of SMT to solve computationally hard, complex problems. XP010262780 relates to an approach for solving satisfiability problems by creating logic circuits that are specialized to solve each problem instance on FPGAs. XP055626149 presents different architectures to solve satisfiability problems in instance-specific hardware. XP019038207 is a review of SAT-based approaches for solving SMT problems. US 2007/021989 A1 discloses using travel planning computer systems to price for air travel with priceable units using a treebased approach. US 2008/140463 A1 relates to a computer-implemented solution for air travel pricing.

### BRIEF DESCRIPTION OF THE DRAWINGS

FIG. 1 illustrates an example retail search system in which the described examples may be implemented.
FIG. 2 illustrates an example method for generating computer-executable instructions for execution by a retail appliance, according to the present examples.
FIG. 3 illustrates an example computer system upon which embodiments described herein may be implemented.
FIG. 4 is an example block diagram of several sample aspects of apparatuses configured to process retail rules and retail offerings as taught herein.

### DETAILED DESCRIPTION

Searching retail offerings is becoming increasingly complicated due to restricted pricing, business rules and constraints, bundling, personalization, and so on. This is true for airline flight search, which has already been demonstrated to be an NP-Complete problem space, but is also true for other retail spaces, as similar rules, constraints, and personalization options are introduced. Among other benefits, examples described provide an efficient solution to the complexity of searching retail offerings for air fares and other products. Additionally, examples further recognize that in the space of retail search for airfares, accurate and up-to-date results are needed in order to avoid inaccurate search results, results which incorporate stale data, and other negative outcomes which may otherwise affect the profitability of the product. Accordingly, examples such as described provide accurate and efficient hardware and software solutions for searching airfare and retail offerings.

Satisfiability modulo theory (SMT) solving has been developed to provide symbolic reasoning about systems and computations. An SMT instance is a logical formula expressed according to a mathematical theory, and the SMT problem is determining whether the formula is satisfiable. Such mathematical theories may include the theory of real numbers, the theory of integers, the theories of data structures such as bit vectors and arrays, and so on. Theories which may be particularly useful for use with the present examples may include the theories of arithmetic, fixed size arrays and fixed-size bit vectors. Each theory may allow for different types of operations. For example, the theory of bit vectors may allow for: string-like operations including concatenation, extraction, and so on; logical operations such as bitwise and, or, not, and so on; and arithmetic operations such as addition, subtractions, multiplication, and so on. In practice, theories may be combined in a single formula.

SMT solvers include algorithmic approaches which have been used in software verification, symbolic analysis, program verification, automatic testing, and other fields. Recent developments in SMT solvers have provided the ability to address increasingly difficult problem domains. For example, SMT solvers implement algorithms which guess a value of a propositional variable, in order to simplify a formula. If the guess is wrong, the algorithm may backtrack. SMT solvers implement intelligent rules for guessing, simplifying and backtracking a propositional value may be used to achieve less complex operations for purpose of solving a larger problem. Additionally, SMT solvers can be employed to find a maximum value of a fixed-size bit vector or array.

Examples such as described enable the generation of verified instructions for execution by a retail appliance. Such instructions may be generated by appropriately translating retail offerings and retail rules for use with a retail appliance. Retail rules and retail offerings are translated into a retail offer domain-specific language (DSL). The translated retail offerings and retail rules are also expressed as constraints according to a satisfiability modulo theory (SMT) language. A hardware-optimized description of the translated retail offerings and retail rules is also generated. A determination is made whether or not the hardware-optimized description correctly processes all retail rules. Computer-executable instructions are generated based on the hardware-optimized description, if the hardware-optimized description correctly processes the retail rules.

Examples are implemented using instructions that are stored with a non-transitory computer-readable storage medium and are executable by a processor to cause the processor to perform an example method as described.

An electronic device for processing retail rules and retail offerings is described. Such a device includes a domain-specific language (DSL) translation engine, for translating retail offerings and retail rules into a retail offer DSL. A satisfiability modulo theory (SMT) engine expresses translated retail offerings and retail rules as constraints according to an SMT language. A hardware-optimized description engine generates a description of the translated retail offerings and retail rules, the description optimized for implementation in a programmable hardware device of a retail appliance. A verification module verifies that the optimized description correctly processes the retail rules. If the optimized description correctly processes the retail rules, a hardware description generation engine generates computer-executable instructions based on the optimized description.

Aspects described herein provide that methods, techniques and actions performed by a computing device are performed programmatically, or as a computer-implemented method. Programmatically means through the use of code, or computer-executable instructions. A programmatically performed step may or may not be automatic.

Examples described herein can be implemented using engines, which may be any combination of hardware and programming to implement the functionalities of the engines or components. In examples described herein, such combinations of hardware and programming may be implemented in a number of different ways. For example, the programming for the components may be processor executable instructions stored on a non-transitory machine-readable storage medium and the hardware for the components may include a processing resource to execute those instructions. In such examples, the machine-readable storage medium may store instructions that, when executed by the processing resource, implement the engines or components. In examples, a system may include the machine-readable storage medium storing the instructions and the processing resource to execute the instructions, or the machine-readable storage medium may be separate but accessible to the system and the processing resource.

Furthermore, aspects described herein may be implemented through the use of instructions that are executable by a processor or combination of processors. These instructions may be carried on a non-transitory computer-readable medium. Machines shown or described with figures below provide examples of processing resources and computer-readable mediums on which instructions for implementing some aspects can be carried and/or executed. In particular, the numerous machines shown in some examples include processor(s) and various forms of memory for holding data and instructions. Examples of computer-readable mediums include permanent memory storage devices, such as hard drives on personal computers or servers. Other examples of computer storage mediums include portable storage units, such as CD or DVD units, flash or solid state memory (such as carried on many cell phones and consumer electronic devices) and magnetic memory. Computers, terminals, network enabled devices (e.g., mobile devices such as cell phones) are all examples of machines and devices that utilize processors, memory, and instructions stored on computer-readable mediums. Additionally, aspects may be implemented in the form of computer programs.

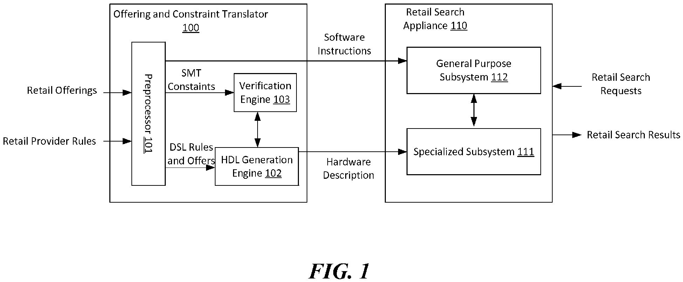

FIG. 1 illustrates an example of a retail search system in which the described examples may be implemented. The retail search system includes an offering and constraint translator 100, containing a preprocessor 101 an hardware description language (HDL) generation engine 102, and a verification engine 103, and a retail search appliance 110, containing a specialized subsystem 111 and a general purpose subsystem 112. In accordance with some examples, preprocessor 101 may receive retail offerings and retail provider rules. The retail offerings and retail provider rules may be provided to preprocessor 101 through various sources, including retail industry feeds. In some examples, preprocessor 101 may process the retail offerings into priceable units (PUs). In some other examples, another computer system may pre-process the retail offerings into PUs.

In accordance with some examples, the retail offerings and retail rules may be related to air travel. In such examples, the retail offerings may include fare components, as described above, and may be in the form of itineraries, industry feed-based fares (such as ATPCO-based fares), and so on. The retail provider rules may include seat maps, fare routes, fare rules, or other appropriate business rules associated with the retail offerings. For example, for air travel retail searches, such retail provider rules may include Saturday night stay requirements, advance purchase requirements, and other time-dependent rules, as described below. The retail provider rules may also include passenger-related rules (e.g., fares for children, frequent fliers, companion fares etc.). Additionally, the retail provider rules may include global constraints, such as a requirement that a first class ticket be sufficiently more expensive than an economy class ticket. Some important structures such as seat maps, fare routes, may be expressed as bit vectors. For example an origin airport may be represented with an 8 bit value, a destination the same, and a flag indicating whether or not it is a round trip a single bit. In this example, a custom hardware architecture supporting an optimized 17 bit word size for the input may be created. Other structures, such as itineraries and fare rules may be represented as arrays. In some other examples, preprocessor 101 may receive additional information about fare and flight availability, for example a code vector may be received for a flight, characterizing seat availability for the flight.

FIG. 1, after receiving the retail offerings and retail provider rules, and processing the retail offerings into PUs, preprocessor 101 translates the retail offers and the retail provider rules into a retail offer domain-specific language (DSL). A DSL is a computer language specialized to a particular application domain, in contrast to a general-purpose language, which may be applicable to a number of application domains. Some widely used DSLs include hypertext markup language (HTML), VHDL for hardware description, and Mathematica for symbolic mathematics. A retail offer DSL may be specialized to a particular retail space, such as an air travel retail space. DSLs for the air travel retail space may allow for efficient and correct expression of retail offerings and retail rules for air travel retail space. For example, such DSLs may provide expression of origin and destination airports, where the value of each expressed airport is limited to values selected from a list of valid airport codes. Additionally, such DSLs may provide for the expression of fare components, for the expression of combinations of fare components into valid itineraries, and so on. As described above, such DSLs may provide for the expression of itineraries and fare rules as arrays. For example, the DSL may support combinators for stating two expressions are equal, less than or greater than. The DSL may direct the building of an abstract syntax tree (AST) from literals (the data values such as origin, destination, and journey segments for example), and then successively combine these with operators to form rule expressions. These rules may be further combined to provide successively more complex restricted offers. The resulting data structure (AST) may initially form a directed graph usable for further translation and optimization. The optimized (translated) representation of these, may for example, be expressed as an array including an ordered set of fare components. Other relevant structures such as seat maps and fare routes may be expressed as bit vectors.

After translating the retail offerings and retail provider rules into the retail offer DSL, preprocessor 101 generates one or more constraints according to an SMT language, based on the translated retail offerings and retail provider rules. Generating the SMT constraints may allow for the rules to be translated into lower level satisfiability problems, and may allow for important optimizations to be made for tackling highly complex retail search problems (e.g., NP-Complete problems such as air travel search). Preprocessor 101 may also remove quantifiers from the resulting mathematical expressions such as "forall," "exists" and other functions which may process over multiple elements. These functions may be comparatively expensive for an SMT solver. Such functions may be more efficiently performed in a recursive manner by software outside of the SMT solver. Accordingly, preprocessor 101 differentiates between application functions which require inductive or recursive processing, from those which process over fixed-size or bounded data.

After translating the retail offers and retail provider rules into the retail offer DSL, preprocessor 101 sends the translated rules and offers to HDL generation engine 102. HDL generation engine 102 may then inspect the translated rules and offers. This may include walking or traversing the abstract syntax tree (AST). This may allow for the translation of functions containing logical connectors, integer comparisons, and bit-level operations (e.g., on bit vectors) to be translated into an HDL such as VHDL or Verilog. In some examples, this may be accomplished using a high-level representation of the HDL (e.g., Chalmers Lava). This high level representation of the HDL may be created using another DSL, representing the circuit description as an AST which may be translated to SMT for further verification or into synthesizable VHDL code.

HDL generation engine 102 generates a hardware description corresponding to the translated rules and offers. This hardware description is optimized for implementation in specialized subsystem 111 of retail search appliance 110. In some examples, the hardware description may be optimized for implementation in specialized subsystem 111 by having a word size based on a size of one type of retail object in the translated retail offerings and retail rules. For example, the hardware description may have a word size corresponding to a number of bits in a fare component in the retail offer DSL. In some other examples, the hardware description may be optimized for a number of processing cores corresponding to a maximum expected number of fare components in an itinerary. Including this number of processing cores may allow for each fare component of an itinerary to be processed in parallel. In some examples, HDL generation engine 102 may develop a pipelined microcode in order to increase throughput of the hardware description by allowing increased clock speed.

The optimized HDL description-which may be represented as an AST-generated by HDL generation engine 102 is translated into SMT for verification in verification engine 103.

Although the HDL description is optimized for implementation in specialized subsystem 111, this optimized HDL description should still satisfy the retail provider rules. Accordingly, HDL generation engine 102 verifies that the optimized HDL description satisfies the rules using verification engine 103. Verification engine 103 translates the optimized HDL description into the SMT language, and compares this translated optimized HDL description to the SMT constraints generated by preprocessor 101. Verification engine 103 then compares the two models using an SMT solver, which may produce a proof that each SMT model processes the retail provider rules with equivalent results. This may be an improvement over verification methods using software testing alone, since such software testing becomes increasingly difficult as rules become more complex.

After generating the hardware description, and verifying the hardware description using verification engine 103, HDL generation engine 102 transmits the hardware description for implementation on a specialized subsystem 111 of a retail search appliance 110. Specialized subsystem 111 may be a digital logic circuit, such as an FPGA, and implementing the HDL on the FPGA may include generating a netlist, and mapping the netlist to the FPGA. In some examples, specialized subsystem 111 may include multiple FPGAs, which may be multiple accelerated FPGAs, to allow for parallel processing of search requests.

Preprocessor 101 of offering and constraint translator 100 also transmits software instructions to a general purpose subsystem 112 of retail search appliance 110. General purpose subsystem 112 is coupled to specialized subsystem 111 (e.g., via a hardware bus such as a PCI Express (PCIe) hardware bus). In example retail appliances where specialized subsystem 111 includes multiple FPGAs, each FPGA may be coupled to general purpose subsystem 111 via a hardware bus such as a PCIe bus. General purpose subsystem 112 may include a general purpose processor such as a CPU. General purpose subsystem 112 may receive retail search requests from a user. In some examples, retail search appliance 110 may be hosted in a cloud environment, and provide functionality through a Software as a Service (SaaS) API using internet protocols. In some examples, the SaaS layer may be implemented using Java or .NET running on the general-purpose subsystem 112. The SaaS layer may handle the network protocols and application processing, and may also be responsible for communications with the retail appliance system RAM. In some examples general purpose subsystem 112 may transfer data to specialized subsystem 111 from system RAM through the use of a direct memory access (DMA) based driver operating over a hardware bus such as a PCIe bus.

In accordance with the present examples, a retail search request may be received from a remote user using the internet protocols. For example, a retail search may include a request to determine a lowest priced fare given a set of fares and an itinerary. General purpose subsystem 112 may determine which functions of each retail search require inductive or recursive processing from functions which process over fixed size or bounded data. Functions which require inductive or recursive processing may be performed by software, for example using a CPU of general purpose subsystem 112. In other examples, functions requiring inductive or recursive processing may be performed using a separate computing device of retail appliance 110 (not shown in FIG. 1 for simplicity). Functions which process over bounded or fixed size data may be performed by specialized subsystem 111 (e.g., using the verified hardware description generated by HDL generation engine 102). For example, data relating to such functions may be sent to specialized subsystem 111 (e.g., over a hardware bus such as a PCIe bus). After processing the bounded or fixed size data, specialized subsystem 111 may return an output to general purpose subsystem 112 via the hardware bus. The output may be combined with the results of the inductive or recursive processing in order to generate retail search results. In some examples, multiple results to a retail search may be desired. When multiple results are desired, after determining a best solution, this solution may be added to a constraint list (thus removing it as a possible search result), and a next best result may be determined. This process may be repeated to determine the desired number of search results. When retail search results have been determined, general purpose subsystem 112 may provide the search results to the requesting user (e.g., via the internet protocols). The user may then select a search result for purchase. For example, if the retail search is an air travel search, the user may select a search results for purchase using an airline's web site, or using an online travel store.

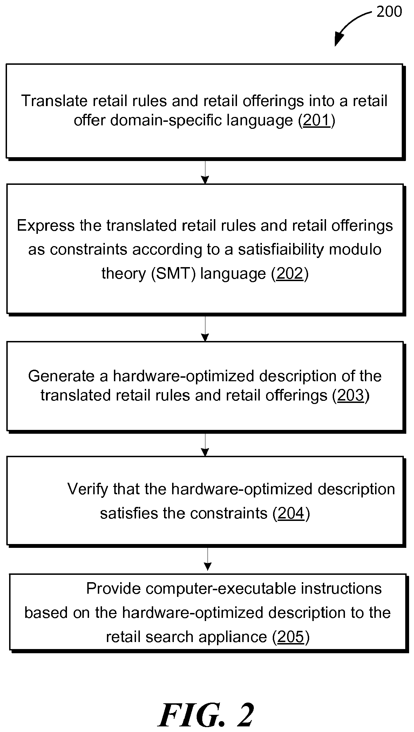

FIG. 2 illustrates an example method 200 for generating computer-executable instructions for execution by a retail appliance, according to the present examples. Method 200 may be implemented in the form of executable instructions stored on a machine readable storage medium and executed by a processing resource and/or in the form of electronic circuitry. For example, method 200 may be described below as being executed or performed by the offering and constraint translator 100 of FIG. 1.

Retail rules and retail offerings are translated into a retail offer domain-specific language (DSL) (201). In some examples, the retail offerings and retail rules may be translated by preprocessor 101 of FIG. 1. In some examples, translating the retail rules and retail offerings may include preprocessing the retail offerings into priceable units, and generating constraints for each priceable unit based on the retail rules. The retail offerings and retail rules may be air travel offerings and air travel rules. If the offerings are air travel offerings, then the retail offerings may include fare components, and may be represented as arrays. Additionally, the retail rules may include air fare rules, and may also be represented as arrays. The retail rules may include geometrical restrictions, where each priceable unit includes fare components matching at least one geometrical restriction.

The retail rules and retail offerings are expressed as constraints according to a satisfiability modulo theory (SMT) language (202). In some examples, this expression may be performed by preprocessor 101 of FIG. 1.

After the retail offerings and retail rules have been expressed according to an SMT language, a hardware-optimized description of the translated retail rules and retail offerings is be generated (203). In some examples, this may be performed by HDL generation engine 102 of FIG. 1. In some examples, the hardware-optimized description may be expressed according to an HDL such as VHDL. According to some examples, the hardware-optimized description may have a word size based, at least in part, on a size of a retail offering.

The hardware-optimized description is then verified, to determine whether or not it satisfies the constraints (204). In some examples, this may be performed by verification engine 103 of FIG. 1. If the hardware-optimized description satisfies the constraints, computer-executable instructions are generated, based on the hardware-optimized description. If the hardware-optimized description does not satisfy the constraints, the computer-executable instructions may not be generated. In some examples, a notification may be generated, indicating that that the hardware-optimized description does not satisfy the constraints. If the constraints are satisfied, computer-executable instructions are generated by HDL generation engine 102 of FIG. 1. In some examples, generating the computer-executable instruction include generating a set of software instructions for execution by a general-purpose processor of the retail appliance, and generating a circuit description for configuration of a hardware device of the retail appliance. The hardware device may be a field-programmable gate array (FPGA) and the circuit description may be a netlist. The software instructions include inductive or recursive operations based on the hardware-optimized description, and the circuit description includes operations which process over fixed-size data. The computer-executable instructions are then provided to the retail search appliance for execution (205).

Examples as described above with respect to the retail search system of FIG. 1 and the method 200 of FIG. 2 can be used in a variety of retail spaces. One retail space is the air travel search space. The highly complex pricing structures of air travel fares may be efficiently and accurately represented for search using example retail devices.

The basic unit of price in air travel is the fare. A fare is a price offered for one-way travel between two cities. This fare may often be the same for travel in either direction between the two cities. Each fare may be published with a set of rules and restrictions regarding its use. While each flight may be paid for by one fare, a single fare may pay for more than one flight. A fare component (FC) refers to a fare and the flights it pays for. A traveler may choose fare combinations for a ticket as long as all fare rules are satisfied. Often, a traveler may wish to select the least expensive combination of fares, but may wish to select more expensive fares (e.g., first class fares, or refundable fares).

Multiple fare components may be combined into a single priceable unit (PU). A PU is a collection of one or more fare components, and represents the smallest group of flights and fares which may be sold on its own. Generally PUs are limited to a specified group of geometries. For example, typical PU geometries may include: one way PUs including a single fare component; round trip or circle trip PUs which may be built from a number of fare components forming a loop; and open jaw PUs which form a loop with one fare component missing. Assuming 4 destinations A, B, C, and D, an example one-way PU may include a single fare component A to B. An example round trip PU may include two fare components-one A to B and the other B to A. An example circle trip PU may include 3 fare components-one A to B, a second B to C, and a third C to A. An example open jaw PU may include 3 fare components-one A to B, a second B to C, and a third C to D.

A variety of fare rules may apply to different PUs. For example, a Saturday night stay restriction may apply to PUs having relatively inexpensive fares. Such a restriction may require that there be a Saturday night between the departure of the first flight in the first fare component and the departure of the first flight in the last fare component of the PU. Other example fare restrictions may require that all fares in a PU be on the same airline, may require that a PU be a round-trip PU to qualify for an inexpensive fare, or may require the PU be purchased a specified number of days in advance. Additionally, fare rules may restrict combinations of fare components within a PU, such as fare rules which require other fares in the same PU to be on the same airline, and rules which provide restrictions on the flight numbers, locations, or departure times of flights.

Additional fare rules may restrict which passengers may be eligible to use a given fare. For example, fare rules may provide for discounts to children, travel agents, senior citizens, frequent fliers, and so on. Other fare rules may allow one passenger's fare to restrict another's-for example, a rule may provide for a discounted companion fare for a second passenger, provided those passengers pay for the fares in the same transaction.

PUs and fare rules are responsible for much of the complexity of the air travel search space. For example, the variety of ways different fare components may be grouped into PUs increases the size of the search space. Additionally, the use of fare rules in PUs may introduce long-distance dependencies between different parts of a trip. For example, a Saturday night stay fare rule may introduce a constraint on the departure times of two flights which are widely separated in time and distance. The presence of multiple passengers on a trip may also significantly increase the complexity of the search, due to the presence of fare rules such as companion fares.

Seat availability and inventory may further complicate an air travel search, as airlines may use seat availability to dynamically adjust prices. Each published fare may be assigned a letter, called a booking code, generally based on the fare's cabin (e.g., coach, business or first) and the fare's price. A code vector may express the number of available seats for each booking code. The above-described techniques may efficiently represent and process these air travel rules and offerings because of the complexity of the offerings, and because, while highly complex, the rules and offerings involve processing over bounded data, often involving data structures of fixed size (e.g., an aircraft may have a fixed number of seats, there may be a fixed number of airports, and so on).

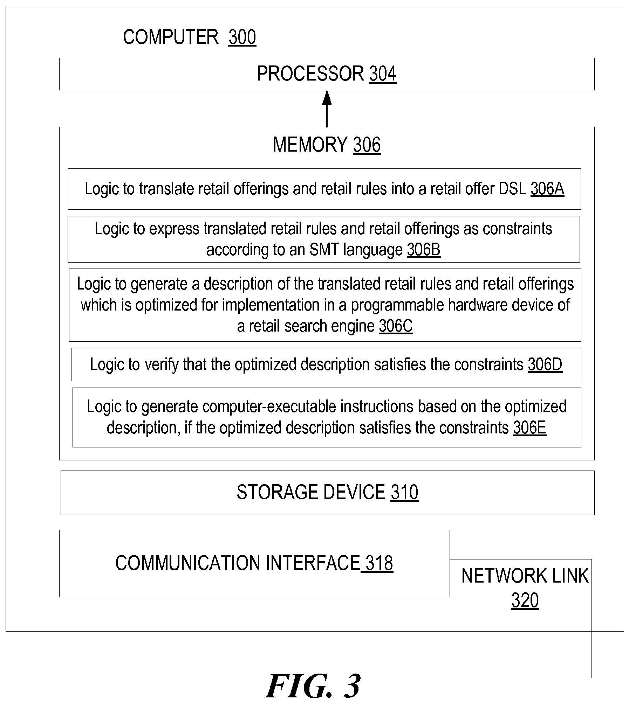

FIG. 3 is a block diagram that illustrates a computer system upon which embodiments described herein may be implemented. For example, in the context of FIG. 1, offering and constraint generator 100 may be implemented using one or more computers such as described by FIG. 3.

In an embodiment, computer system 300 includes processor 304, memory 306 (including non-transitory memory), storage device 310, and communication interface 318. Computer system 300 includes at least one processor 304 for processing information. Computer system 300 also includes the memory 306, such as a random access memory (RAM) or other dynamic storage device, for storing information and instructions to be executed by processor 304. For example, instructions stored in memory 306 may be executed to implement the method 200. In some examples, memory 306 can store (i) logic 306A for translating retail offerings and retail rules into a retail offer DSL, (ii) logic 306B for expressing translated retail rules and retail offerings as constraints according to an SMT language , (iii) logic 306C for generating a description of the translated retail rules and retail offerings which is optimized for implementation in a programmable hardware device of a retail search engine, (iv) logic 306D for verifying that the optimized description satisfies the constraints, and (v) logic 306E for generating computer-executable instructions based on the optimized description, if the optimized description satisfies the constraints, in accordance with some aspects.

Memory 306 also may be used for storing temporary variables or other intermediate information during execution of instructions to be executed by processor 304. Computer system 300 may also include a read only memory (ROM) or other static storage device for storing static information and instructions for processor 304. The storage device 310, such as a magnetic disk or optical disk, is provided for storing information and instructions. The communication interface 318 may enable the computer system 300 to communicate using a network (e.g., for transmitting computer-executable instructions to a retail search appliance 110 as in FIG. 1) through use of the network link 320 and any one of a number of well-known transfer protocols (e.g., Hypertext Transfer Protocol (HTTP)). Examples of networks include a local area network (LAN), a wide area network (WAN), the Internet, mobile telephone networks, Plain Old Telephone Service (POTS) networks, and wireless data networks (e.g., Wi-Fi and WiMAX networks).

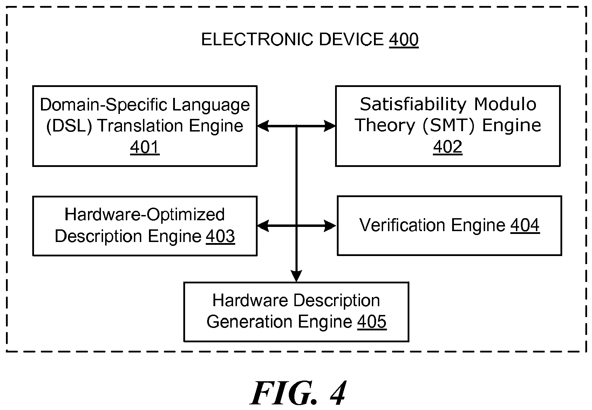

FIG. 4 shows an example electronic device 400 for processing retail rules and retail offerings, represented as a series of interrelated engines. With respect to FIG. 4, the electronic device 400 includes: a domain-specific language (DSL) translation engine 401, for translating retail offerings and retail rules, into a retail offer DSL; a satisfiability modulo theory (SMT) engine 402, for expressing the translated retail rules and retail offerings as constraints according to an SMT language; a hardware-optimized description engine 403, for generating a description of the translated retail rules and retail offerings which is optimized for implementation in a programmable hardware device of a retail search appliance; a verification engine 404, for verifying that the optimized description satisfies the constraints; and a hardware description generation engine 405, for generating computer-executable instructions for transmission to and execution by the retail search appliance, where the instructions are based on the optimized description. In some examples, each of the engines of FIG. 4 may be implemented by appropriate hardware and software. For example, the functions of DSL translation engine 401 and SMT engine 402 may be provided by preprocessor 101 of FIG. 1. The functions of hardware-optimized description engine 403 and hardware description generation engine 405 may be provided using HDL generation engine 102 of FIG. 1. Similarly, the functions of verification engine 404 may be provided using verification engine 103 of FIG. 1.

## Claims

1. A method for generating verified instructions for execution by a retail search appliance, the retail search appliance including a general-purpose processor and a configurable hardware processing device, the method comprising:
translating (201) retail rules and retail offerings into a retail offer domain-specific language, DSL;
generating constraints in satisfiability modulo theory, SMT, language based on the translated retail rules and retail offerings and differentiating application functions requiring inductive or recursive processing from those which process over fixed-size or bounded data;
generating (203), based on the DSL version of the retail rules and the retail offerings, a hardware description that is optimized for the configurable hardware processing device of the retail search appliance, wherein the configurable hardware processing device processes over fixed-size data needed to search the retail offerings;
translating the hardware description into SMT language;
verifying (204) that the SMT version of the hardware description satisfies the previously generated constraints;
if the SMT version of the hardware description satisfies the previously generated constraints, generating:
software instructions for execution by the general-purpose processor of the retail search appliance, the software instructions including inductive or recursive operations needed to search the retail offerings; and
a circuit description for configuration of the hardware processing device of the retail search appliance; and
sending (205) the software instructions to the general-purpose processor of the retail search appliance, and the circuit description to the configurable hardware processing device of the retail search appliance.

2. The method of claim 1, wherein the retail search appliance is configured to provide search results responsive to the retail offerings using a combination of the general-purpose processor applying the software instructions and processing by the configurable hardware processing device as configured based on the hardware description.

3. The method of claim 1, further comprising, at the retail search appliance:
configuring the configurable hardware processing device based on the hardware description; and
providing search results using a combination of the general-purpose processor applying the software instructions and processing by the configurable hardware processing device as configured based on the hardware description.

4. The method of any one of claims 1-3, wherein the hardware description includes a word size corresponding to the number of bits in one type of retail object in the translated retail rules and retail offerings.

5. The method of any one of claims 1-4, wherein the configurable hardware processing device is a field-programmable gate array.

6. The method of claim 1, wherein translating the retail rules and one or more retail offerings into the retail offer DSL includes pre-processing offerings into priceable units and generating constraints for each priceable unit based on the retail rules.

7. The method of claim 6, wherein the retail rules and the retail offerings are air travel retail rules and air travel retail offerings, respectively.

8. A system (100) for generating verified instructions for execution by a retail search appliance (110), the retail search appliance (110) including a general-purpose processor (112) and a configurable hardware processing device (111), the system (100) comprising:
a processor; and
a non-transitory computer readable media storing instructions which, when executed by the processor, cause the system (100) to perform operations comprising:
translating retail rules and retail offerings into a retail offer domain-specific language, DSL;
generating constraints in satisfiability modulo theory, SMT, language based on the translated retail rules and retail offerings and differentiating application functions requiring inductive or recursive processing from those which process over fixed-size or bounded data;
generating, based on the DSL version of the retail rules and the retail offerings, a hardware description that is optimized for the configurable hardware processing device (111) of the retail search appliance (110), wherein the configurable hardware processing device (111) processes over fixed-size data needed to search the retail offerings;
translating the hardware description into SMT language;
verifying that the SMT version of the hardware description satisfies the previously generated constraints;
if the SMT version of the hardware description satisfies the previously generated constraints, generating:
software instructions for execution by the general-purpose processor of the retail search appliance, the software instructions including inductive or recursive operations needed to search the retail offerings; and
a circuit description for configuration of the hardware processing device of the retail search appliance; and
sending the software instructions to the general-purpose processor (112) of the retail search appliance (110), and the circuit description to the configurable hardware processing device (111) of the retail search appliance (110).

9. The system (100) of claim 8, wherein the retail search appliance (110) is configured to provide search results responsive to the retail offerings using a combination of the general-purpose processor (112) applying the software instructions and processing by the configurable hardware processing device (111) as configured based on the hardware description.

10. The system (100) of claim 8, the operations further comprising, at the retail search appliance (110):
configuring the configurable hardware processing device (111) based on the hardware description; and
providing search results using a combination of the general-purpose processor (112) applying the software instructions and processing by the configurable hardware device (111) as configured based on the hardware description.

11. The system (100) of any one of claims 8-10, wherein the hardware description includes a word size corresponding to the number of bits in one type of retail object in the translated retail rules and retail offerings.

12. The system (100) of any one of claims 8-11, wherein the configurable hardware processing device (111) is a field-programmable gate array.

13. The system (100) of claim 8, wherein translating the retail rules and one or more retail offerings into the retail offer DSL includes pre-processing offerings into priceable units and generating constraints for each priceable unit based on the retail rules.

14. The system (100) of claim 13, wherein the retail rules and the retail offerings are air travel retail rules and air travel retail offerings, respectively.

15. A non-transitory computer readable medium (306) storing instructions which, when executed by a processor (304), cause a system to perform operations comprising:
translating retail rules and retail offerings into a retail offer domain-specific language, DSL;
generating constraints in satisfiability modulo theory, SMT, language based on the translated retail rules and retail offerings and differentiating application functions requiring inductive or recursive processing from those which process over fixed-size or bounded data;
generating, based on the DSL version of the retail rules and the retail offerings, a hardware description that is optimized for a configurable hardware processing device of a retail search appliance, wherein the configurable hardware processing device processes over fixed-size data needed to search the retail offerings;
translating the hardware description into SMT language;
verifying that the SMT version of the hardware description satisfies the previously generated constraints;
if the SMT version of the hardware description satisfies the previously generated constraints, generating:
software instructions for execution by a general-purpose processor of the retail search appliance, the software instructions including inductive or recursive operations needed to search the retail offerings; and
a circuit description for configuration of the hardware processing device of the retail search appliance; and
sending the software instructions to the general-purpose processor of the retail search appliance, and the circuit description to the configurable hardware processing device of the retail search appliance.

## Patentansprüche

1. Verfahren zum Erzeugen verifizierter Anweisungen zur Ausführung durch eine Einzelhandelssuchmaschine, wobei die Einzelhandelssuchmaschine einen Allzweckprozessor und eine konfigurierbare Hardwareverarbeitungsvorrichtung beinhaltet, wobei das Verfahren umfasst:
Übersetzen (201) von Einzelhandelsregeln und Einzelhandelsangeboten in eine domänenspezifische Sprache für Einzelhandelsangebote, DSL;
Erzeugen von Einschränkungen in der Satisfiability-Modulo-Theories-Sprache, SMT-Sprache, basierend auf den übersetzten Einzelhandelsregeln und Einzelhandelsangeboten und Unterscheiden von Anwendungsfunktionen, die induktive oder rekursive Verarbeitung erfordern, von solchen, die über eine feste Größe oder begrenzte Daten verarbeiten;
Erzeugen (203), basierend auf der DSL-Version der Einzelhandelsregeln und Einzelhandelangebote einer Hardwarebeschreibung, die für die konfigurierbare Hardwareverarbeitungsvorrichtung der Einzelhandelssuchmaschine optimiert ist, wobei die konfigurierbare Hardwareverarbeitungsvorrichtung über Daten mit fester Größe verarbeitet, die erforderlich sind, um die Einzelhandelsangebote zu suchen;
Übersetzen der Hardwarebeschreibung in die SMT-Sprache;
Verifizieren (204), ob die SMT-Version der Hardwarebeschreibung die zuvor erzeugten Einschränkungen erfüllt;
wenn die SMT-Version der Hardwarebeschreibung die zuvor erzeugten Einschränkungen erfüllt, Erzeugen von:
Softwareanweisungen zur Ausführung durch den Allzweckprozessor der Einzelhandelssuchmaschine, wobei die Softwareanweisungen induktive oder rekursive Operationen beinhalten, die erforderlich sind, um die Einzelhandelsangebote zu suchen; und
einer Schaltungsbeschreibung zur Konfiguration der Hardwareverarbeitungsvorrichtung der Einzelhandelssuchmaschine; und
Senden (205) der Softwareanweisungen an den Allzweckprozessor der Einzelhandelssuchmaschine und der Schaltungsbeschreibung an die konfigurierbare Hardwareverarbeitungsvorrichtung der Einzelhandelssuchmaschine.

2. Verfahren nach Anspruch 1, wobei die Einzelhandelssuchmaschine dazu konfiguriert ist, Suchergebnisse als Reaktion auf die Einzelhandelsangebote unter Verwendung einer Kombination aus dem Allzweckprozessor, der die Softwareanweisungen anwendet, und Verarbeiten durch die konfigurierbare Hardwareverarbeitungsvorrichtung, wie basierend auf der Hardwarebeschreibung konfiguriert, bereitzustellen.

3. Verfahren nach Anspruch 1, das weiter an der Einzelhandelssuchmaschine Folgendes umfasst:
Konfigurieren der konfigurierbaren Hardwareverarbeitungsvorrichtung basierend auf der Hardwarebeschreibung; und
Bereitstellen von Suchergebnissen unter Verwendung einer Kombination aus dem Allzweckprozessor, der die Softwareanweisungen anwendet, und dem Verarbeiten durch die konfigurierbare Hardwareverarbeitungsvorrichtung, wie basierend auf der Hardwarebeschreibung konfiguriert.

4. Verfahren nach einem der Ansprüche 1-3, wobei die Hardwarebeschreibung eine Wortgröße beinhaltet, die der Anzahl von Bits in einem Typ von Einzelhandelsobjekt in den übersetzten Einzelhandelsregeln und Einzelhandelsangeboten entspricht.

5. Verfahren nach einem der Ansprüche 1-4, wobei die konfigurierbare Hardwareverarbeitungsvorrichtung ein feldprogrammierbares Gate-Array ist.

6. Verfahren nach Anspruch 1, wobei das Übersetzen der Einzelhandelsregeln und eines oder mehrerer Einzelhandelsangebote in die Einzelhandelsangebot-DSL das Vorverarbeiten von Angeboten in bepreisbare Einheiten und das Erzeugen von Einschränkungen für jede bepreisbare Einheit basierend auf den Einzelhandelsregeln beinhaltet.

7. Verfahren nach Anspruch 6, wobei die Einzelhandelsregeln und die Einzelhandelsangebote jeweils Einzelhandelsregeln für Flugreisen und Einzelhandelsangebote für Flugreisen sind.

8. System (100) zum Erzeugen verifizierter Anweisungen zur Ausführung durch eine Einzelhandelssuchmaschine (110), wobei die Einzelhandelssuchmaschine (110) einen Allzweckprozessor (112) und eine konfigurierbare Hardwareverarbeitungsvorrichtung (111) beinhaltet, wobei das System (100) umfasst:
einen Prozessor; und
ein nichtflüchtiges, computerlesbares Medium, das Anweisungen speichert, die, wenn sie von dem Prozessor ausgeführt werden, das System (100) veranlassen, Operationen durchzuführen, die Folgendes umfassen:
Übersetzen von Einzelhandelsregeln und Einzelhandelsangeboten in eine domänenspezifische Sprache für Einzelhandelsangebote, DSL;
Erzeugen von Einschränkungen in der Satisfiability-Modulo-Theories-Sprache, SMT-Sprache, basierend auf den übersetzten Einzelhandelsregeln und Einzelhandelsangeboten und Unterscheiden von Anwendungsfunktionen, die induktive oder rekursive Verarbeitung erfordern, von solchen, die über eine feste Größe oder begrenzte Daten verarbeiten;
Erzeugen einer Hardwarebeschreibung basierend auf der DSL-Version der Einzelhandelregeln und Einzelhandelsangebote einer Hardwarebeschreibung, die für die konfigurierbare Hardwareverarbeitungsvorrichtung (111) der Einzelhandelssuchmaschine (110) optimiert ist, wobei die konfigurierbare Hardwareverarbeitungsvorrichtung (111) über Daten mit fester Größe verarbeitet, die erforderlich sind, um die Einzelhandelsangebote zu suchen;
Übersetzen der Hardwarebeschreibung in die SMT-Sprache;
Verifizieren, ob die SMT-Version der Hardwarebeschreibung die zuvor erzeugten Einschränkungen erfüllt;
wenn die SMT-Version der Hardwarebeschreibung die zuvor erzeugten Einschränkungen erfüllt, Erzeugen von:
Softwareanweisungen zur Ausführung durch den Allzweckprozessor der Einzelhandelssuchmaschine, wobei die Softwareanweisungen induktive oder rekursive Operationen beinhalten, die erforderlich sind, um die Einzelhandelsangebote zu suchen; und
einer Schaltungsbeschreibung zur Konfiguration der Hardwareverarbeitungsvorrichtung der Einzelhandelssuchmaschine; und
Senden der Softwareanweisungen an den Allzweckprozessor (112) der Einzelhandelssuchmaschine (110) und der Schaltungsbeschreibung an die konfigurierbare Hardwareverarbeitungsvorrichtung (111) der Einzelhandelssuchmaschine (110).

9. System (100) nach Anspruch 8, wobei die Einzelhandelssuchmaschine (110) dazu konfiguriert ist, Suchergebnisse als Reaktion auf die Einzelhandelsangebote unter Verwendung einer Kombination aus dem Allzweckprozessor (112), der die Softwareanweisungen anwendet, und Verarbeiten durch die konfigurierbare Hardwareverarbeitungsvorrichtung (111), wie basierend auf der Hardwarebeschreibung konfiguriert, bereitzustellen.

10. System (100) nach Anspruch 8, wobei die Operationen an der Einzelhandelssuchmaschine (110) weiter Folgendes umfassen:
Konfigurieren der konfigurierbaren Hardwareverarbeitungsvorrichtung (111) basierend auf der Hardwarebeschreibung; und
Bereitstellen von Suchergebnissen unter Verwendung einer Kombination aus dem Allzweckprozessor (112), der die Softwareanweisungen anwendet, und dem Verarbeiten durch die konfigurierbare Hardwarevorrichtung (111), wie basierend auf der Hardwarebeschreibung konfiguriert.

11. System (100) nach einem der Ansprüche 8-10, wobei die Hardwarebeschreibung eine Wortgröße beinhaltet, die der Anzahl von Bits in einem Typ von Einzelhandelsobjekt in den übersetzten Einzelhandelsregeln und Einzelhandelsangeboten entspricht.

12. System (100) nach einem der Ansprüche 8-11, wobei die konfigurierbare Hardwareverarbeitungsvorrichtung (111) ein feldprogrammierbares Gate-Array ist.

13. System (100) nach Anspruch 8, wobei das Übersetzen der Einzelhandelsregeln und eines oder mehrerer Einzelhandelsangebote in die Einzelhandelsangebot-DSL das Vorverarbeiten von Angeboten in bepreisbare Einheiten und das Erzeugen von Einschränkungen für jede bepreisbare Einheit basierend auf den Einzelhandelsregeln beinhaltet.

14. System (100) nach Anspruch 13, wobei die Einzelhandelsregeln und die Einzelhandelsangebote jeweils Einzelhandelsregeln für Flugreisen und Einzelhandelsangebote für Flugreisen sind.

15. Nichtflüchtiges, computerlesbares Medium (306), das Anweisungen speichert, die, wenn sie von einem Prozessor (304) ausgeführt werden, ein System veranlassen, Operationen durchzuführen, die Folgendes umfassen:
Übersetzen von Einzelhandelsregeln und Einzelhandelsangeboten in eine domänenspezifische Sprache für Einzelhandelsangebote, DSL;
Erzeugen von Einschränkungen in der Satisfiability-Modulo-Theories-Sprache, SMT-Sprache, basierend auf den übersetzten Einzelhandelsregeln und Einzelhandelsangeboten und Unterscheiden von Anwendungsfunktionen, die induktive oder rekursive Verarbeitung erfordern, von solchen, die über eine feste Größe oder begrenzte Daten verarbeiten;
Erzeugen, basierend auf der DSL-Version der Einzelhandelregeln und der Einzelhandelangebote einer Hardwarebeschreibung, die für eine konfigurierbare Hardwareverarbeitungsvorrichtung einer Einzelhandelssuchmaschine optimiert ist, wobei die konfigurierbare Hardwareverarbeitungsvorrichtung über Daten mit fester Größe verarbeitet, die erforderlich sind, um die Einzelhandelsangebote zu suchen;
Übersetzen der Hardwarebeschreibung in die SMT-Sprache;
Verifizieren, ob die SMT-Version der Hardwarebeschreibung die zuvor erzeugten Einschränkungen erfüllt;
wenn die SMT-Version der Hardwarebeschreibung die zuvor erzeugten Einschränkungen erfüllt, Erzeugen von:
Softwareanweisungen zur Ausführung durch einen Allzweckprozessor der Einzelhandelssuchmaschine, wobei die Softwareanweisungen induktive oder rekursive Operationen beinhalten, die erforderlich sind, um die Einzelhandelsangebote zu suchen; und
einer Schaltungsbeschreibung zur Konfiguration der Hardwareverarbeitungsvorrichtung der Einzelhandelssuchmaschine; und
Senden der Softwareanweisungen an den Allzweckprozessor der Einzelhandelssuchmaschine und der Schaltungsbeschreibung an die konfigurierbare Hardwareverarbeitungsvorrichtung der Einzelhandelssuchmaschine.

## Revendications

1. Procédé de génération d'instructions vérifiées pour une exécution par un appareil de recherche de vente au détail, l'appareil de recherche de vente au détail incluant un processeur à usage général et un dispositif de traitement de matériel configurable, le procédé comprenant :
la traduction (201) de règles de vente au détail et d'offres de vente au détail dans un langage spécifique à un domaine d'offre de vente au détail, DSL ;
la génération de contraintes dans un langage de satisfaisabilité modulo des théories, SMT, basé sur les règles de vente au détail et les offres de vente au détail traduites et la différenciation de fonctions d'application nécessitant un traitement inductif ou récursif de celles qui traitent des données de taille fixe ou délimitées ;
la génération (203), sur la base de la version DSL des règles de vente au détail et des offres de vente au détail, d'une description de matériel qui est optimisée pour le dispositif de traitement de matériel configurable de l'appareil de recherche de vente au détail, dans lequel le dispositif de traitement de matériel configurable traite des données de taille fixe nécessaires pour rechercher les offres de vente au détail ;
la traduction de la description de matériel en langage SMT ;
la vérification (204) que la version SMT de la description de matériel satisfait les contraintes générées précédemment ;
si la version SMT de la description de matériel satisfait les contraintes générées précédemment, la génération :
d'instructions logicielles pour une exécution par le processeur à usage général de l'appareil de recherche de vente au détail, les instructions logicielles incluant des opérations inductives ou récursives nécessaires pour rechercher les offres de vente au détail ; et
d'une description de circuit pour une configuration du dispositif de traitement de matériel de l'appareil de recherche de vente au détail ; et
l'envoi (205) des instructions logicielles au processeur à usage général de l'appareil de recherche de vente au détail et de la description de circuit au dispositif de traitement de matériel configurable de l'appareil de recherche de vente au détail.

2. Procédé selon la revendication 1, dans lequel l'appareil de recherche de vente au détail est configuré pour fournir des résultats de recherche en réponse aux offres de vente au détail à l'aide d'une combinaison du processeur à usage général appliquant les instructions logicielles et d'un traitement au moyen du dispositif de traitement de matériel configurable tel que configuré sur la base de la description de matériel.

3. Procédé selon la revendication 1, comprenant en outre, au niveau de l'appareil de recherche de vente au détail :
la configuration du dispositif de traitement de matériel configurable sur la base de la description de matériel ; et
la fourniture de résultats de recherche à l'aide une combinaison du processeur à usage général appliquant les instructions logicielles et d'un traitement au moyen du dispositif de traitement de matériel configurable tel que configuré sur la base de la description de matériel.

4. Procédé selon l'une quelconque des revendications 1-3, dans lequel la description de matériel inclut une taille de mot correspondant au nombre de bits dans un type d'objet de vente au détail dans les règles de vente au détail et les offres de vente au détail traduites.

5. Procédé selon l'une quelconque des revendications 1-4, dans lequel le dispositif de traitement de matériel configurable est une matrice prédiffusée programmable par l'utilisateur.

6. Procédé selon la revendication 1, dans lequel la traduction des règles de vente au détail et d'une ou de plusieurs offres de vente au détail dans l'offre de vente au détail DSL inclut un prétraitement d'offres en unités tarifables et la génération de contraintes pour chaque unité tarifable sur la base des règles de vente au détail.

7. Procédé selon la revendication 6, dans lequel les règles de vente au détail et les offres de vente au détail sont respectivement des règles de vente au détail de voyages aériens et des offres de vente au détail de voyages aériens.

8. Système (100) pour générer des instructions vérifiées destinées pour une exécution par un appareil de recherche de vente au détail (110), l'appareil de recherche de vente au détail (110) incluant un processeur à usage général (112) et un dispositif de traitement de matériel configurable (111), le système (100) comprenant :
un processeur ; et
un support non transitoire lisible par ordinateur stockant des instructions qui, lorsqu'elles sont exécutées par le processeur, amènent le système (100) à effectuer des opérations comprenant :
la traduction de règles de vente au détail et d'offres de vente au détail dans un langage spécifique au domaine d'offre de vente au détail, DSL ;
la génération de contraintes dans un langage de satisfaisabilité modulo des théories, SMT, basé sur les règles de vente au détail et les offres de vente au détail traduites et la différenciation de fonctions d'application nécessitant un traitement inductif ou récursif de celles qui traitent des données de taille fixe ou délimitées ;
la génération, sur la base de la version DSL des règles de vente au détail et des offres de vente au détail, d'une description de matériel qui est optimisée pour le dispositif de traitement de matériel configurable (111) de l'appareil de recherche de vente au détail (110), dans lequel le dispositif de traitement de matériel configurable (111) traite des données de taille fixe nécessaires pour rechercher les offres de vente au détail ;
la traduction de la description de matériel en langage SMT ;
la vérification que la version SMT de la description de matériel satisfait les contraintes générées précédemment ;
si la version SMT de la description de matériel satisfait les contraintes générées précédemment, la génération :
d'instructions logicielles pour une exécution par le processeur à usage général de l'appareil de recherche de vente au détail, les instructions logicielles incluant des opérations inductives ou récursives nécessaires pour rechercher les offres de vente au détail ; et
d'une description de circuit pour une configuration du dispositif de traitement de matériel de l'appareil de recherche de vente au détail ; et
l'envoi des instructions logicielles au processeur à usage général (112) de l'appareil de recherche de vente au détail (110) et de la description de circuit au dispositif de traitement de matériel configurable (111) de l'appareil de recherche de vente au détail (110).

9. Système (100) selon la revendication 8, dans lequel l'appareil de recherche de vente au détail (110) est configuré pour fournir des résultats de recherche en réponse aux offres de vente au détail à l'aide d'une combinaison du processeur à usage général (112) appliquant les instructions logicielles et d'un traitement au moyen du dispositif de traitement de matériel configurable (111) tel que configuré sur la base de la description de matériel.

10. Système (100) selon la revendication 8, les opérations comprenant en outre, au niveau de l'appareil de recherche de vente au détail (110) :
la configuration du dispositif de traitement de matériel configurable (111) sur la base de la description de matériel ; et
la fourniture de résultats de recherche à l'aide d'une combinaison du processeur à usage général (112) appliquant les instructions logicielles et d'un traitement au moyen du dispositif matériel configurable (111) tel que configuré sur la base de la description du matériel.

11. Système (100) selon l'une quelconque des revendications 8-10, dans lequel la description de matériel inclut une taille de mot correspondant au nombre de bits dans un type d'objet de vente au détail dans les règles de vente au détail et les offres de vente au détail traduites.

12. Système (100) selon l'une quelconque des revendications 8-11, dans lequel le dispositif de traitement de matériel configurable (111) est une matrice prédiffusée programmable par l'utilisateur.

13. Système (100) selon la revendication 8, dans lequel la traduction des règles de vente au détail et d'une ou de plusieurs offres de vente au détail dans l'offre de vente au détail DSL inclut un prétraitement d'offres en unités tarifables et une génération de contraintes pour chaque unité tarifable sur la base des règles de vente au détail.

14. Système (100) selon la revendication 13, dans lequel les règles de vente au détail et les offres de vente au détail sont respectivement des règles de vente au détail de voyages aériens et des offres de vente au détail de voyages aériens.

15. Support non transitoire lisible par ordinateur (306) stockant des instructions qui, lorsqu'elles sont exécutées par un processeur (304), amènent un système à effectuer des opérations comprenant :
la traduction de règles de vente au détail et d'offres de vente au détail dans un langage spécifique au domaine d'offre de vente au détail, DSL ;
la génération de contraintes dans un langage de satisfaisabilité modulo des théories, SMT, basé sur les règles de vente au détail et les offres de vente au détail traduites et la différenciation de fonctions d'application nécessitant un traitement inductif ou récursif de celles qui traitent des données de taille fixe ou délimitées ;
la génération, sur la base de la version DSL des règles de vente au détail et des offres de vente au détail, d'une description de matériel qui est optimisée pour un dispositif de traitement de matériel configurable d'un appareil de recherche de vente au détail, dans lequel le dispositif de traitement de matériel configurable traite des données de taille fixe nécessaires pour rechercher les offres de vente au détail ;
la traduction de la description de matériel en langage SMT ;
la vérification que la version SMT de la description de matériel satisfait les contraintes générées précédemment ;
si la version SMT de la description de matériel satisfait les contraintes générées précédemment, la génération :
d'instructions logicielles pour une exécution par un processeur à usage général de l'appareil de recherche de vente au détail, les instructions logicielles incluant des opérations inductives ou récursives nécessaires pour rechercher les offres de vente au détail ; et
d'une description de circuit pour une configuration du dispositif de traitement de matériel de l'appareil de recherche de vente au détail ; et
l'envoi des instructions logicielles au processeur à usage général de l'appareil de recherche de vente au détail et de la description de circuit au dispositif de traitement de matériel configurable de l'appareil de recherche de vente au détail.
